# EUROPEAN PATENT APPLICATION

(11) **EP 4 676 178 A1**
(43) Date of publication of application: **07.01.2026**
(21) Application number: 23945672.6
(22) Date of filing: 22.11.2023
(51) Int. Cl.: H10B 12/00

(54) **SEMICONDUCTOR STRUCTURE AND FORMING METHOD THEREFOR, AND MEMORY**

(30) Priority: 19.07.2023 CN 202310889740
(71) Applicant: CXMT Corporation, Hefei City, Anhui Province 230601 (CN)
(72) Inventor: LI, Xiaojie, Hefei, Anhui 230601 (CN)
(74) Representative: Gulde & Partner
(86) International application number: PCT/CN2023/133402
(87) International publication number: WO 2025/015792

(57) **Abstract**

Embodiments of the present disclosure disclose a semiconductor structure and a forming method therefor, and a memory. The forming method includes the steps as follows. An initial stacked structure is provided, where the initial stacked structure includes first sacrificial layers and second sacrificial layers that are alternately stacked; multiple first trenches running through the initial stacked structure are formed; lateral etching is performed through the first trenches to remove first portions of each of the first sacrificial layers to form multiple first filling regions; a dielectric layer is formed in each of the first filling regions; the second sacrificial layers are removed to form multiple second filling regions, and a bit line layer is formed in each of the second filling regions; and a retained second portion of each of the first sacrificial layers is removed to form multiple cavities.

## Description

### CROSS-REFERENCE TO RELATED APPLICATIONS

The present disclosure is based on and claims priority of the Chinese Patent Application No. 202310889740.4, filed on July 19, 2023 and entitled "SEMICONDUCTOR STRUCTURE AND FORMING METHOD THEREFOR, AND MEMORY". The above-referenced application is incorporated herein by reference in its entirety.

### TECHNICAL FIELD

The present disclosure relates to the field of semiconductor technologies, and specifically, to a semiconductor structure and a forming method therefor, and a memory.

### BACKGROUND

The degree of integration of a two-dimensional semiconductor storage apparatus is mainly determined by an area occupied by a storage unit. In this case, the degree of integration of the two-dimensional semiconductor storage apparatus is largely affected by the level of a fine pattern formation technology. To overcome a limitation of the level of a fine pattern technology on the degree of integration of a semiconductor storage apparatus, a three-dimensional semiconductor storage apparatus including three-dimensionally arranged storage units has recently been proposed.

However, a conventional three-dimensional semiconductor storage apparatus and a forming method therefor still have some defects. How to further improve the performance of the three-dimensional semiconductor storage apparatus becomes a problem that needs to be resolved urgently at present.

### SUMMARY

In view of this, embodiments of the present disclosure provide a semiconductor structure and a forming method therefor, and a memory.

According to a first aspect of the present disclosure, a forming method for a semiconductor structure is provided, and includes the steps as follows.

An initial stacked structure is provided, where the initial stacked structure includes first sacrificial layers and second sacrificial layers that are alternately stacked;
multiple first trenches running through the initial stacked structure are formed;
lateral etching is performed through the first trenches to remove first portions of each of the first sacrificial layers to form multiple first filling regions;
a dielectric layer is formed in each of the first filling regions;
the second sacrificial layers are removed to form multiple second filling regions, and a bit line layer is formed in each of the second filling regions; and
a retained second portion of each of the first sacrificial layers is removed to form multiple cavities.

In the foregoing solution, the multiple first trenches are arranged in a first direction, the distance between a sidewall of each of the first trenches parallel to the first direction and an edge of the initial stacked structure in a second direction is H1, the distance between two adjacent ones of the first trenches in the first direction is H2, and the ratio of H2 to H1 is greater than 2; and the first direction is perpendicular to the second direction and both are perpendicular to a stacking direction of the initial stacked structure.

In the foregoing solution, that the second sacrificial layers are removed to form multiple second filling regions, and a bit line layer is formed in each of the second filling regions includes the steps as follows.

Lateral etching is performed through the first trenches to remove third portions of each of the second sacrificial layers to form multiple third filling regions;
a conductive material is filled in each of the third filling regions, where the conductive material is filled between retained fourth portions of the second sacrificial layers;
the fourth portions are removed to form multiple fourth filling regions; and
the conductive material is filled in each of the fourth filling regions, where the conductive materials in the third filling regions and the fourth filling regions constitute the bit line layers.

In the foregoing solution, after the dielectric layer is formed in each of the first filling regions, the dielectric layer is filled between the retained second portions of each of the first sacrificial layers; and

That the fourth portions are removed and the second portions are removed includes the steps as follows.

A second trench running through the initial stacked structure is formed after the conductive material is filled in each of the third filling regions, where the second trench exposes sidewalls of the fourth portions and sidewalls of the second portions;
lateral etching is performed through the second trench to remove the fourth portions; and
lateral etching is performed through the second trench to remove the second portions.

In the foregoing solution, the method further includes the steps as follows.

A third sacrificial layer is filled in at least a partial number of the first trenches before lateral etching is performed through the first trenches to remove the first portions of each of the first sacrificial layers; and
the third sacrificial layer is removed after the dielectric layer is formed in each of the first filling regions, to form a fourth trench, where the fourth trench exposes sidewalls of the second portions.

In the foregoing solution, that the second sacrificial layers are removed to form multiple second filling regions, and a bit line layer is formed in each of the second filling regions includes the steps as follows.

A fourth sacrificial layer is filled in each of the first trenches, and lateral etching is performed through the fourth trench to remove a fifth portion of each of the second sacrificial layers to form multiple fifth filling regions;
a conductive material is filled in each of the fifth filling regions;
the fourth sacrificial layer is removed, and retained sixth portions of each of the second sacrificial layers are removed through the first trenches to form multiple sixth filling regions; and
the conductive material is filled in each of the sixth filling regions, where the conductive materials in the fifth filling regions and the sixth filling regions constitute the bit line layers.

In the foregoing solution, the multiple first trenches are arranged in a first direction, and the method further includes the steps as follows.

A third trench is formed between two adjacent ones of the first trenches after the dielectric layer is formed in each of the first filling regions, where the third trench runs through the initial stacked structure and exposes a sidewall of each of the second portions; the distance between the third trench and one of the first trenches adjacent to the third trench in the first direction is H3, the distance between a sidewall of the third trench or each of the first trenches parallel to the first direction and an edge of the initial stacked structure in a second direction is H1, and the ratio of H3 to H1 is greater than 2; and the first direction is perpendicular to the second direction and both are perpendicular to a stacking direction of the initial stacked structure.

In the foregoing solution, that the second sacrificial layers are removed to form multiple second filling regions, and a bit line layer is formed in each of the second filling regions includes the steps as follows.

Lateral etching is performed through the third trench to remove a seventh portion of each of the second sacrificial layers to form multiple seventh filling regions;
a conductive material is filled in each of the seventh filling regions;
lateral etching is performed through the first trenches to remove retained eighth portions of each of the second sacrificial layers to form multiple eighth filling regions; and
the conductive material is filled in each of the eighth filling regions, where the conductive materials in the seventh filling regions and the eighth filling regions constitute the bit line layers.

That a retained second portion of each of the first sacrificial layers is removed includes the step as follows. Lateral etching is performed through the third trench to remove the retained second portion of each of the first sacrificial layers.

According to a second aspect of the present disclosure, a semiconductor structure is provided, including:
a stacked structure, including bit line layers and dielectric layers that are alternately stacked, where
the stacked structure includes multiple first trenches running through the stacked structure;
each of the bit line layers has multiple first bit line portions located on two sides of each of the first trenches in a first direction and a second bit line portion located on one side of each of the multiple first bit line portions in a second direction, and the second bit line portion extends in the first direction; and
dielectric layers between adjacent ones of the first trenches have cavities.

In the foregoing solution, the multiple first trenches are arranged in the first direction, the width of the second bit line portion in the second direction is H1, the width of each of the first bit line portions in the first direction is H2, and the ratio of H2 to H1 is greater than 2; and the first direction is perpendicular to the second direction and both are perpendicular to a stacking direction of the stacked structure.

In the foregoing solution, a range of the ratio of H2 to H1 is 3 to 6.

In the foregoing solution, each of the cavities is located between adjacent ones of the first bit line portions in the stacking direction, and each of the dielectric layers exists between each of the cavities and each of two adjacent ones of the first trenches in the first direction.

In the foregoing solution, a range of the ratio of H2 to H1 is greater than 6, the stacked structure further includes a third trench running through the stacked structure, the third trench is located between two adjacent ones of the first trenches, the distance between the third trench and one of the first trenches adjacent to the third trench in the first direction is H3, and the ratio of H3 to H1 ranges from 3 to 6.

In the foregoing solution, the cavities are located between adjacent ones of the first bit line portions in the stacking direction and between adjacent ones of the second bit line portions in the stacking direction, the cavities are located on two sides of the third trench in the first direction and on one side thereof in the second direction, each of the dielectric layers exists between each of the first trenches and each of the cavities, and the third trench and the cavities are in communication.

According to a third aspect of the present disclosure, a memory is provided, including the semiconductor structure according to any one of the foregoing solutions.

In the embodiments of the present disclosure, the first trenches running through the initial stacked structure are formed in the initial stacked structure. By performing lateral etching through the first trenches to remove the first portions of each of the first sacrificial layers, after the dielectric layers are filled in regions in which the first portions of each of the first sacrificial layers are removed, and the second sacrificial layers are removed and the bit line layers are formed, the second portions of the first sacrificial layers are removed, so that each of the cavities is formed between the adjacent two bit line layers in the stacking direction of the initial stacked structure. In this way, a coupling effect between the adjacent two bit line layers in the stacking direction of the initial stacked structure can be alleviated, and the parasitic capacitance of the adjacent two bit line layers in the stacking direction of the initial stacked structure can be reduced, thereby providing the performance of the semiconductor structure.

### BRIEF DESCRIPTION OF DRAWINGS

FIG. 1 is a schematic flowchart of a forming method of a semiconductor structure according to an embodiment of the present disclosure;
FIG. 2 to FIG. 33 are schematic structural diagrams of a semiconductor structure in a fabrication procedure according to an embodiment of the present disclosure;
FIG. 34 is a schematic structural diagram 1 of a semiconductor structure according to an embodiment of the present disclosure; and
FIG. 35 is a schematic structural diagram 2 of a semiconductor structure according to an embodiment of the present disclosure.

### DESCRIPTION OF EMBODIMENTS

To make the technical solutions and advantages of the embodiments of the present disclosure clearer, the technical solutions of the present disclosure are further described below in detail with reference to the accompanying drawings and the embodiments. Although example implementation methods of the present disclosure are shown in the accompanying drawings, it should be understood that the present disclosure may be implemented in various forms without being limited by the implementations described herein. Instead, these implementations are provided to develop a more thorough understanding of the present disclosure and to fully convey the scope of the present disclosure to a person skilled in the art.

In the following paragraphs, the present disclosure is described more specifically by way of example with reference to the accompanying drawings. The advantages and features of the present disclosure will be clearer from the following description and claims. It should be noted that the accompanying drawings are presented in a highly simplified form and are not drawn to exact scale, and are merely intended to conveniently and clearly assist in describing the embodiments of the present disclosure.

It may be understood that meanings of "on", "over", and "above" in the present disclosure should be understood in the widest way, so that "on" means that it is "on" something with no intermediate feature or layer (that is, directly on something), and further includes the meaning that it is "on" something with an intermediate feature or layer.

In addition, for ease of description, spatially relative terms such as "on", "over", "above", "up", and "upper" may be adopted herein to describe a relationship between an element or feature and another element or feature shown in the figures. The spatially relative terms are intended to cover different orientations of the device in application or operation in addition to the orientation depicted in the accompanying drawings. The apparatus may be oriented in another manner (rotated by 90 degrees or in another orientation), and the spatially relative descriptors adopted herein can likewise be interpreted accordingly.

In the embodiments of the present disclosure, the term "substrate" refers to a material on which a subsequent material layer is added. The substrate itself may be patterned. A material added to the top of the substrate may be patterned or may remain unpatterned. In addition, the substrate may include multiple semiconductor materials, e.g., silicon, silicon germanium, germanium, gallium arsenide, and silicon carbide. Alternatively, the substrate may be made of a non-conductive material, e.g., glass, plastic, or a sapphire wafer.

In the embodiments of the present disclosure, the term "layer" refers to a material part including a region having a thickness. The layer may extend over the whole of a lower or upper structure, or may have a range smaller than the range of the lower or upper structure. In addition, the layer may be a region of a homogeneous or heterogeneous continuous structure whose thickness is less than the thickness of a continuous structure. For example, the layer may be located between the top surface and the bottom surface of the continuous structure, or the layer may be located between any horizontal surface pair at the top surface and the bottom surface of the continuous structure. The layer may extend horizontally, vertically, and/or along an inclined surface. The layer may include multiple sublayers. For example, an interconnection layer may include one or more conductors and contact sublayers (in which interconnection lines and/or via-hole contacts are formed) and one or more dielectric sublayers.

In the embodiments of the present disclosure, the terms "first", "second", and the like are intended to distinguish between similar objects but do not necessarily indicate a specific order or sequence.

A semiconductor structure involved in the embodiments of the present disclosure is at least a part of a structure to be utilized in a subsequent fabrication procedure to form a final component. Herein, the final component may include a memory, and the memory includes but is not limited to a dynamic random access memory (DRAM). The following takes the dynamic random access memory as an example for description.

A horizontal bit line and a vertical word line are easily integrated in a currently proposed architecture of a three-dimensional dynamic random access memory, which therefore becomes a mainstream development direction. Because of continuous improvement of a memory density requirement, a distance between one bit line and another bit line in an architecture of horizontal bit lines in the three-dimensional dynamic random access memory is becoming increasingly smaller. In this case, a coupling effect is generated between adjacent bit lines and the parasitic capacitance is easily formed. In addition, to ensure a relatively small resistance of the bit line, a material with a relatively small resistance, e.g., a metal material, is usually selected as the material of the bit line. However, this further aggravates a problem of a coupling effect between bit lines and the parasitic capacitance, seriously affecting reliability of the memory. How to alleviate the coupling effect between the adjacent bit lines and reduce the parasitic capacitance between the adjacent bit lines becomes an urgent problem to be resolved.

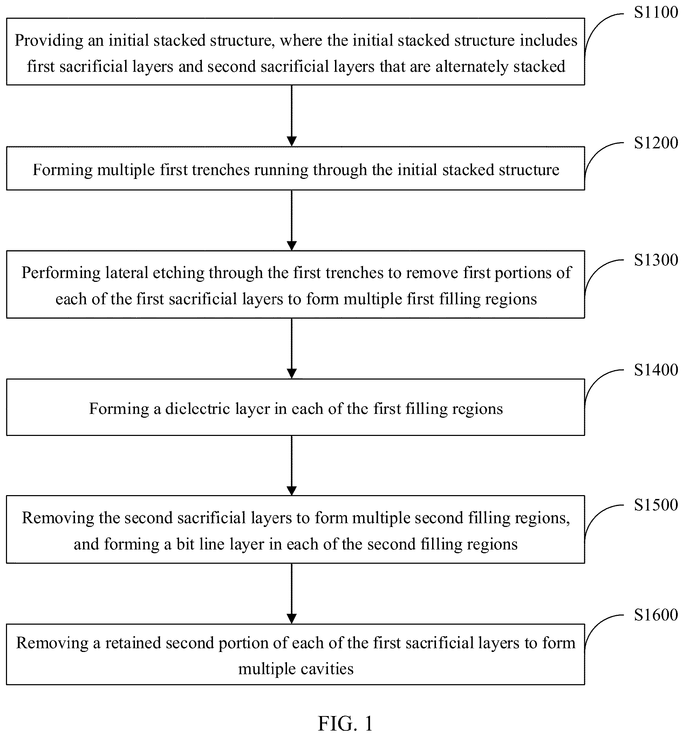

Based on the foregoing problem, an embodiment of the present disclosure provides a forming method for a semiconductor structure. FIG. 1 is a schematic flowchart of a forming method for a semiconductor structure according to an embodiment of the present disclosure. As shown in FIG. 1, the forming method for a semiconductor structure provided in this embodiment of the present disclosure includes the following steps:
S1100. An initial stacked structure is provided, where the initial stacked structure includes first sacrificial layers and second sacrificial layers that are alternately stacked.
S1200. Multiple first trenches running through the initial stacked structure are formed.
S1300. Lateral etching is performed through the first trenches to remove first portions of each of the first sacrificial layers to form multiple first filling regions.
S 1400. A dielectric layer is formed in each of the first filling regions.
S1500. The second sacrificial layers are removed to form multiple second filling regions, and a bit line layer is formed in each of the second filling regions.
S1600. A retained second portion of each of the first sacrificial layers is removed to form multiple cavities.

It should be understood that the steps shown in FIG. 1 are not exclusive, and another step may be performed before, after, or between any steps in the operations shown. The sequence of the steps shown in FIG. 1 may be adjusted according to an actual requirement.

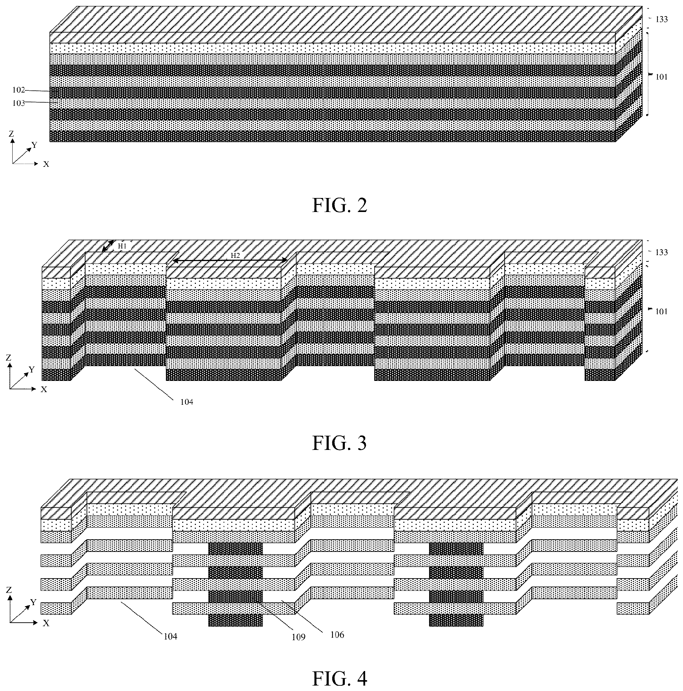

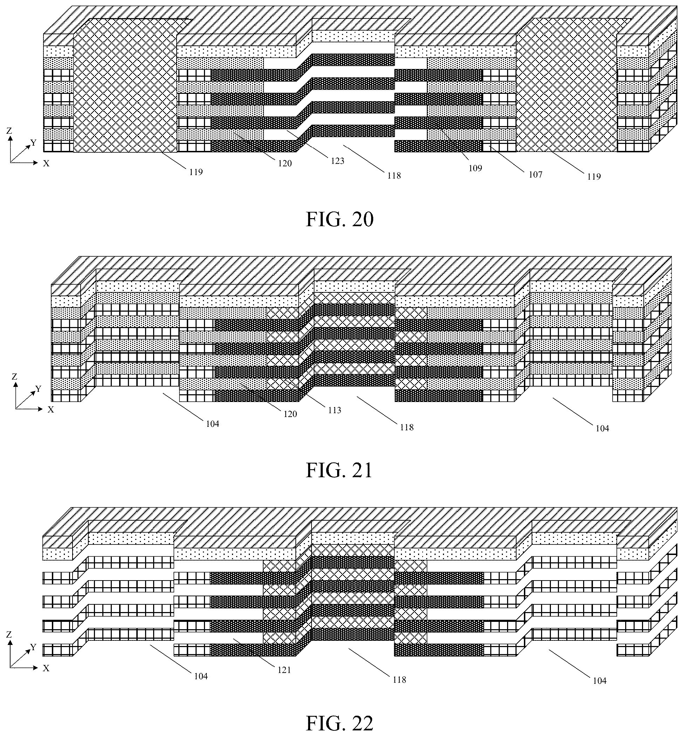

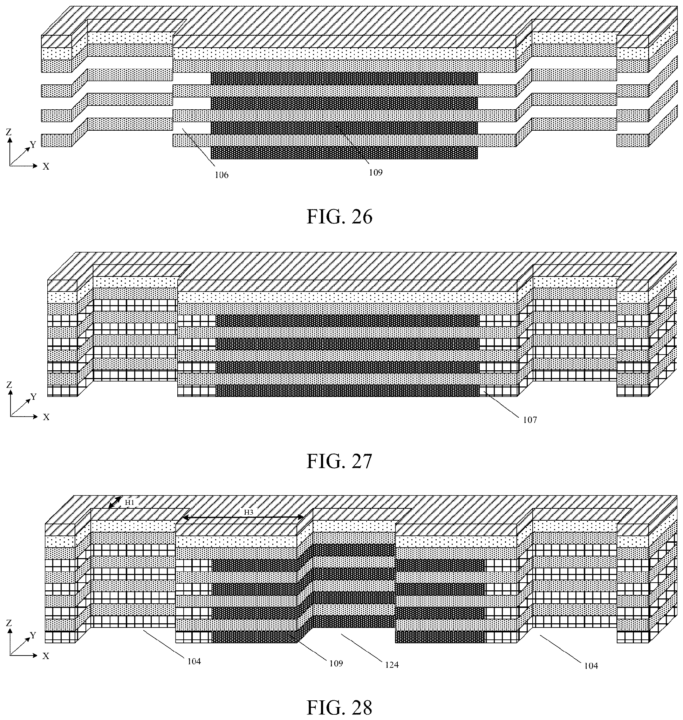

FIG. 2 to FIG. 33 are schematic structural diagrams of a formation procedure of a semiconductor structure according to an embodiment of the present disclosure. The following describes in detail the forming method for a semiconductor structure provided in this embodiment of the present disclosure with reference to FIG. 1 and FIG. 2 to FIG. 33.

Referring to FIG. 2, the step of S1100 is performed, that is, an initial stacked structure 101 is provided, where the initial stacked structure 101 includes first sacrificial layers 102 and second sacrificial layers 103 that are alternately stacked.

It should be noted that a quantity of the first sacrificial layers 102 and the second sacrificial layers 103 shown in FIG. 2 is merely an example, and a specific quantity of the first sacrificial layers 102 and the second sacrificial layers 103 in the initial stacked structure 101 is not limited in the present disclosure.

In some specific examples, the first sacrificial layers 102 and the second sacrificial layers 103 may be formed by a deposition process or an epitaxy (Epitaxy, EPI) process. One of the first sacrificial layers 102 is first formed on a substrate (not shown in FIG. 2), and then one of the second sacrificial layers 103 is formed on the first sacrificial layer 102. This procedure is repeated to form the initial stacked structure 101 with the first sacrificial layers 102 and the second sacrificial layers 103 that are alternately stacked.

It should be noted that selection of the materials of the first sacrificial layers 102 and the second sacrificial layers 103 needs to consider reducing the impact on the second sacrificial layers 103 when the first sacrificial layers 102 are subsequently laterally removed, and reducing the impact on the first sacrificial layers 102 when the second sacrificial layers 103 are laterally removed. In some specific examples, the material of the first sacrificial layers 102 may be silicon germanium, and the material of the second sacrificial layers 103 may be silicon.

In this embodiment of the present disclosure, the deposition process includes but is not limited to chemical vapor deposition (CVD), low pressure chemical vapor deposition (LPCVD), plasma enhanced chemical vapor deposition (PECVD), physical vapor deposition (PVD), and atomic layer deposition (ALD).

In some specific examples, as shown in FIG. 2, the method further includes the step as follows. A mask layer 133 is formed on the initial stacked structure 101. The mask layer 133 may be a composite layer or a single layer, and for example, the mask layer 133 may include at least one of a silicon oxide layer, a silicon nitride layer, and a silicon oxynitride layer.

Referring to FIG. 3, the step of S1200 is performed, that is, multiple first trenches 104 running through the initial stacked structure 101 are formed.

In some specific examples, a method for forming the first trenches 104 includes but is not limited to dry etching. Herein, a dry etching process may be an etching process with relatively good directionality such as plasma etching, sputter etching, ion beam etching, or reactive ion etching.

In this embodiment of the present disclosure, as shown in FIG. 3, the multiple first trenches 104 are arranged in a first direction, a distance between a sidewall of each of the first trenches 104 parallel to the first direction and an edge of the initial stacked structure 101 in a second direction is H1, and a distance between two adjacent ones of the first trenches 104 in the first direction is H2. The first direction is perpendicular to the second direction and both are perpendicular to a stacking direction of the initial stacked structure 101.

In this embodiment of the present disclosure, the first direction is an X direction, the second direction is a Y direction, and the stacking direction of the initial stacked structure 101 is a Z direction.

Herein, for a correspondence between H2 and H1, embodiments of the present disclosure provide multiple cases, and methods for forming a bit line layer, a dielectric layer, and a cavity are also different accordingly. Embodiments of the present disclosure provide three solutions. The following first takes a case in which the ratio of H2 to H1 is greater than 2 and less than 6 as an example to specifically describe Solution 1.

Referring to FIG. 4, the step of S1300 is performed, that is, lateral etching is performed through the first trenches 104 to remove first portions of each of the first sacrificial layers 102 to form multiple first filling regions 106.

In some specific examples, a method for removing the first portions of each of the first sacrificial layers 102 includes but is not limited to a wet etching process.

As shown in FIG. 4, remaining first sacrificial layers 102 are second portions 109 of the first sacrificial layers 102. A retained second portion 109 of each of the first sacrificial layers 102 is located between adjacent ones of the first trenches 104.

It may be understood that, when the first sacrificial layers 102 are laterally etched through the first trenches 104, the first sacrificial layer 102 between two adjacent ones of the first trenches 104 is etched simultaneously from two sides in the first direction. In this case, the first filling regions 106 are located on two sides of each of the second portions 109 in the first direction. In this embodiment of the present disclosure, the ratio of H2 to H1 is greater than 2 and less than 6. In this way, when the first sacrificial layers 102 are laterally etched through the first trenches 104, the first sacrificial layers 102 on the two sides of the first trenches 104 in the second direction can be completely removed, and the first sacrificial layer 102 between the two adjacent ones of the first trenches 104 in the first direction can retain the second portion 109. The retained second portion 109 of each of the first sacrificial layers 102 herein is located between the two adjacent ones of the first trenches 104 in the first direction, and the retained second portion 109 of each of the first sacrificial layers 102 can provide a support function.

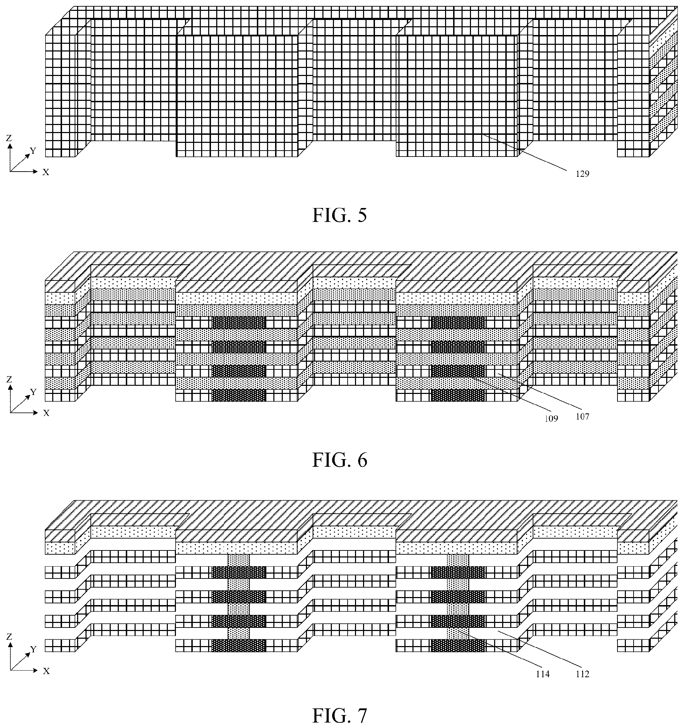

Referring to FIG. 5 to FIG. 6, the step of S1400 is performed, that is, a dielectric layer 107 is formed in each of the first filling regions 106.

In some specific examples, the material of the dielectric layers 107 may be a low dielectric constant material, and the low dielectric constant material includes but is not limited to one of silicon oxide, silicon nitride, silicon carbide, silicon carbide nitride, or silicon oxynitride.

It may be understood that the dielectric layer 107 in this embodiment of the present disclosure adopts the low dielectric constant material, so that a coupling effect between adjacent two bit line layers in the stacking direction of the subsequently formed initial stacked structure 101 can be alleviated and the parasitic capacitance can be reduced.

It should be noted that selection of the material of the dielectric layers 107 herein needs to consider reducing the impact on the dielectric layer 107 when a remaining first sacrificial layer 102, a remaining second sacrificial layer 103, and some conductive material layers are removed in a subsequent process.

In some specific examples, dielectric material layers 129 may be first deposited in the first filling regions 106, and on a sidewall and the top of the initial stacked structure 101. Then, the dielectric material layers 129 on the sidewall and the top of the initial stacked structure 101 are removed by adopting an etching process, and the dielectric material layers 129 located in the first filling regions 106 are retained to form the dielectric layer 107.

Referring to FIG. 7 to FIG. 13, the step of S1500 is performed, that is, the second sacrificial layers 103 are removed to form multiple second filling regions, and a bit line layer 108 is formed in each of the second filling regions.

In some embodiments, as shown in FIG. 7 to FIG. 13, that the second sacrificial layers 103 are removed to form multiple second filling regions, and a bit line layer 108 is formed in each of the second filling regions includes the steps as follows. Lateral etching is performed through the first trenches 104 to remove third portions of each of the second sacrificial layers 103 to form multiple third filling regions 112; a conductive material layer 113 is filled in each of the third filling regions 112, where the conductive material layer 113 is filled between retained fourth portions 114 of the second sacrificial layers 103; the fourth portions 114 are removed to form multiple fourth filling regions 115; and the conductive material layer 113 is filled in each of the fourth filling regions 115, where the conductive material layers 113 in the third filling regions 112 and the fourth filling regions 115 constitute the bit line layers 108.

It may be understood that the second sacrificial layers 103 in this embodiment of the present disclosure are removed in two steps. The third portions of each of the second sacrifice layers are first removed to form the third filling regions 112, and the conductive material layer 113 is filled in each of the third filling regions 112. Then, the fourth portions 114 of the second sacrificial layers 103 are removed to form the fourth filling regions 115, and the conductive material layer 113 is filled in each of the fourth filling regions 115. When the third portions are removed, the fourth portions 114 can provide a support function. When the fourth portions 114 are removed, the conductive material layer 113 filled in each of the third filling regions 112 can provide a support function.

In some specific examples, the material of the conductive material layer 113 includes but is not limited to metal tungsten. A method for forming the conductive material layer includes but is not limited to a deposition process.

It may be understood that, in this embodiment of the present disclosure, tungsten is adopted as the material of the bit line layer 108, to reduce the resistance of a bit line and improve the performance of a memory.

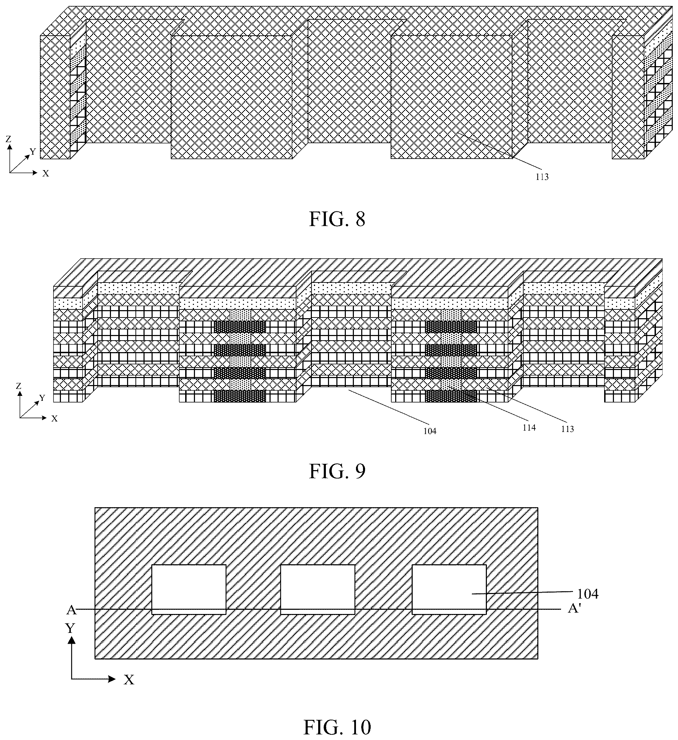

In some specific examples, as shown in FIG. 8 and FIG. 9, after the multiple third filling regions 112 are formed, the conductive material layers 113 may be first deposited in each of the third filling regions 112, and on the sidewall and the top of the initial stacked structure 101. Then, the conductive material layers 113 on the sidewall and the top of the initial stacked structure 101 are removed in the stacking direction of the initial stacked structure 101 by adopting an etching process, and the conductive material layer 113 located in each of the third filling regions 112 is retained.

It should be noted that, to more clearly display the initial stacked structure 101 between adjacent ones of the first trenches 104, FIG. 2 to FIG. 9 are partial views. For example, FIG. 9 is a three-dimensional diagram of the upper part of FIG. 10 cut in an AA' direction.

In some embodiments, as shown in FIG. 9 to FIG. 12, after the dielectric layer 107 is formed in each of the first filling regions 106, the dielectric layer 107 is filled between the retained second portions 109 of each of the first sacrificial layers 102. That the fourth portions 114 are removed and the second portions 109 are removed includes the steps as follows. A second trench 116 running through the initial stacked structure 101 is formed after the conductive material layer 113 is filled in each of the third filling regions 112, where the second trench 116 exposes sidewalls of the fourth portions 114 and sidewalls of the second portions 109; lateral etching is performed through the second trench 116 to remove the fourth portions 114; and lateral etching is performed through the second trench 116 to remove the second portions 109.

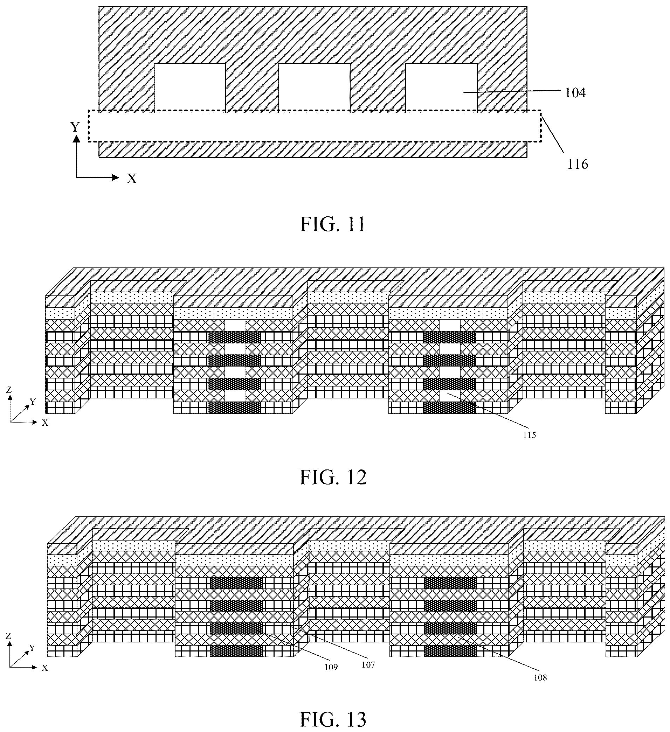

In some specific examples, as shown in FIG. 11, the second trench 116 extends in the first direction and is in communication with the first trenches 104.

In some specific examples, a method for removing the fourth portions 114 includes but is not limited to the wet etching process.

It may be understood that two sidewalls of each of the second portions 109 of each of the first sacrificial layers 102 in the first direction are covered by the dielectric layer 107, and two sidewalls of each of the fourth portions 114 of the second sacrificial layers 103 in the first direction are covered by the conductive material layers 113; and the first trenches 104 do not expose the second portions 109 of the first sacrificial layers 102, and the first trenches 104 do not expose the fourth portions 114 of the second sacrificial layers 103. In this case, the second portions 109 and the fourth portions 114 cannot be removed by utilizing the first trenches 104. In this embodiment of the present disclosure, by forming the second trench 116 running through the initial stacked structure 101, the second trench 116 exposes the sidewalls of the fourth portions 114 and the sidewalls of the second portions 109, so that the second portions 109 and the fourth portions 114 can be removed from the second trench 116.

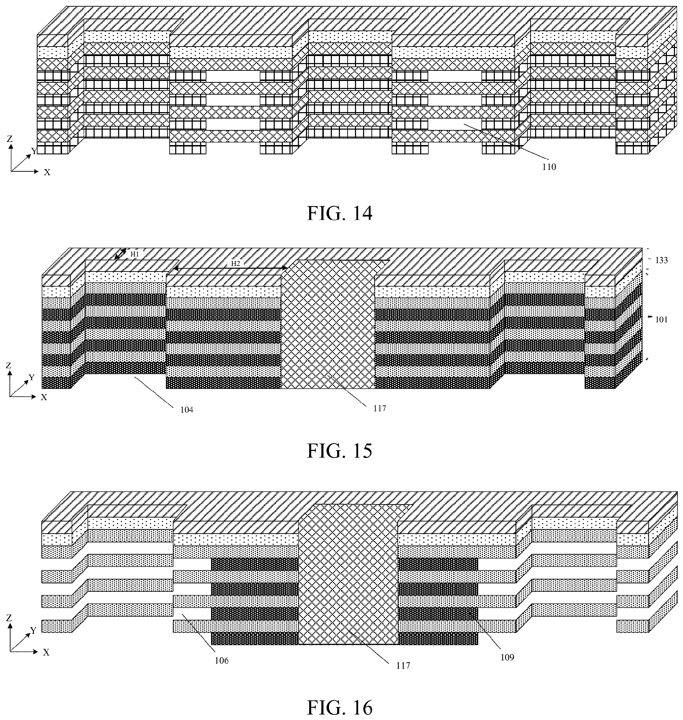

Referring to FIG. 14, the step of S1600 is performed, that is, the retained second portion 109 of each of the first sacrificial layers 102 is removed to form multiple cavities 110.

In some specific examples, a method for removing the second portions 109 includes but is not limited to wet etching.

In some specific examples, the method further includes the step as follows. The mask layer 133 is removed after the cavities 110 are formed.

It may be understood that in this embodiment of the present disclosure, the multiple cavities 110 are formed between adjacent two bit line layers 108 in the stacking direction of the initial stacked structure 101, so that a coupling effect of the adjacent two bit line layers in the stacking direction of the initial stacked structure 101 can be alleviated, and the parasitic capacitance of the adjacent two bit line layers in the stacking direction of the initial stacked structure 101 can be reduced, thereby improving the performance of the memory.

In the case in which the ratio of H2 to H1 is greater than 2 and less than 6, the following method is further provided in this embodiment of the present disclosure to form the bit line layer 108, the dielectric layer 107, and the cavities 110. The following specifically describes Solution 2 with reference to FIG. 15 to FIG. 24.

In some embodiments, as shown in FIG. 15 to FIG. 18, the method further includes the steps as follows. A third sacrificial layer 117 is filled in at least a partial number of the first trenches 104 before lateral etching is performed through the first trenches 104 to remove the first portions of each of the first sacrificial layers 102; and the third sacrificial layer 117 is removed after the dielectric layer 107 is formed in each of the first filling regions 106, to form a fourth trench 118, where the fourth trench 118 exposes sidewalls of the second portions 109.

It should be noted that, a case in which the third sacrificial layer 117 is filled in one of the first trenches 104 is an example in FIG. 15. Alternatively, the third sacrificial layer 117 may be filled in each of multiple first trenches 104 that are continuous in the first direction.

It may be understood that in the foregoing embodiment, the third sacrificial layer 117 is first filled in the part of the first trenches 104. A part of the first sacrificial layers 102 is removed by utilizing the first trenches 104 in which the third sacrificial layer 117 is not filled, and the second portions 109 of the first sacrificial layers 102 are removed by utilizing the fourth trench after the third sacrificial layer is removed.

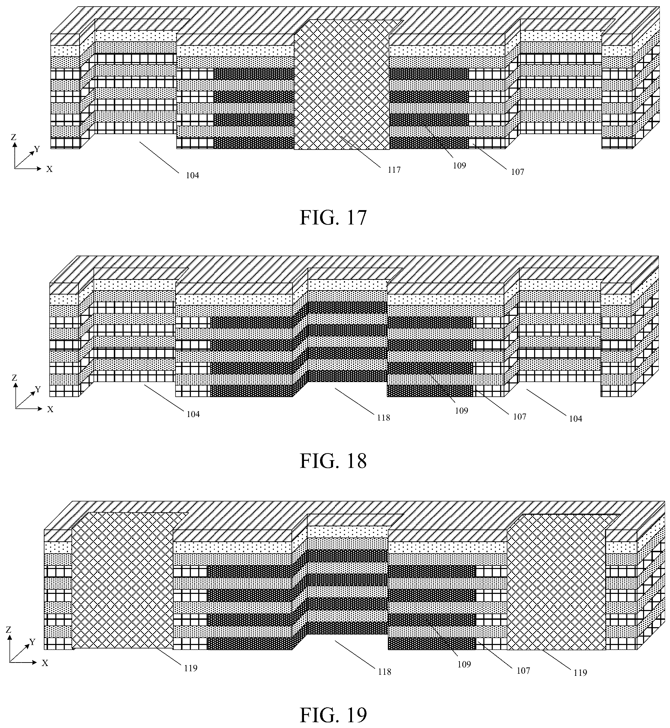

In some embodiments, as shown in FIG. 19 to FIG. 23, that the second sacrificial layers 103 are removed to form multiple second filling regions, and a bit line layer 108 is formed in each of the second filling regions includes the steps as follows. A fourth sacrificial layer 119 is filled in each of the first trenches 104, and lateral etching is performed through the fourth trench 118 to remove a fifth portion of each of the second sacrificial layers 103 to form multiple fifth filling regions 123; a conductive material layer 113 is filled in each of the fifth filling regions 123; the fourth sacrificial layer 119 is removed, and retained sixth portions 120 of each of the second sacrificial layers 103 are removed through the first trenches 104 to form multiple sixth filling regions 121; and the conductive material layer 113 is filled in each of the sixth filling regions 121, where the conductive material layers 113 in the fifth filling regions 123 and the sixth filling regions 121 constitute the bit line layers 108.

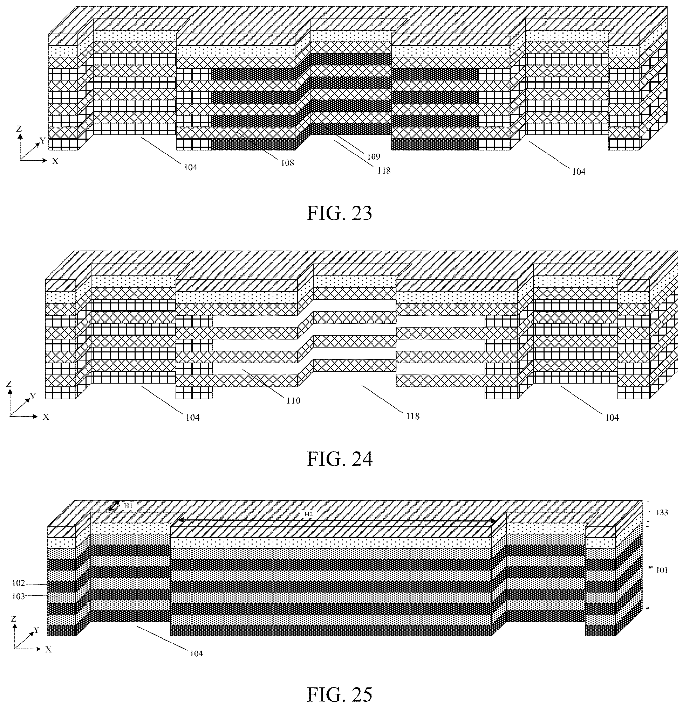

As shown in FIG. 24, the method further includes the step as follows. A retained second portion 109 of each of the first sacrificial layers 102 is removed to form multiple cavities 110. The cavities herein are in communication with the fourth trench 118.

In some specific examples, the method further includes the step as follows. The mask layer 133 is removed after the cavities 110 are formed.

The ratio of H2 to H1 may alternatively be greater than 6. The following specifically describes, in a case in which the ratio of H2 to H1 is greater than 6 with reference to FIG. 25 to FIG. 33, a procedure of forming the bit line layer 108, the dielectric layer 107, and the cavities 110 in Solution 3.

In some embodiments, as shown in FIG. 25 to FIG. 28, the multiple first trenches 104 are arranged in the first direction, and the method further includes the steps as follows. A third trench 124 is formed between two adjacent ones of the first trenches 104 after the dielectric layer 107 is formed in each of the first filling regions 106, where the third trench 124 runs through the initial stacked structure 101 and exposes a sidewall of each of the second portions 109; a distance between the third trench 124 and one of the first trenches 104 adjacent to the third trench in the first direction is H3, a distance between a sidewall of the third trench 124 or each of the first trenches 104 parallel to the first direction and an edge of the initial stacked structure 101 in the second direction is H1, and the ratio of H3 to H1 is greater than 2; and the first direction is perpendicular to the second direction and both are perpendicular to the stacking direction of the initial stacked structure 101.

Herein, after the third trench 124 is formed, the ratio of H3 to H1 is greater than 2 and less than 6.

It may be understood that in comparison with Solution 1, in Solution 3, that is, in the case in which the ratio of H2 to H1 is greater than 6, after the first portions of each of the first sacrificial layers 102 are removed by utilizing the first trenches 104, a relatively large part of the first sacrificial layers 102 is retained between two adjacent ones of the first trenches 104. After the dielectric layer 107 is formed in each of the first filling regions 106, the third trench 124 is formed between two adjacent ones of the first trenches 104, and the third trench 124 exposes the sidewalls of the second portions 109. In this way, the second portions 109 can be removed through the third trench 124 in a subsequent process.

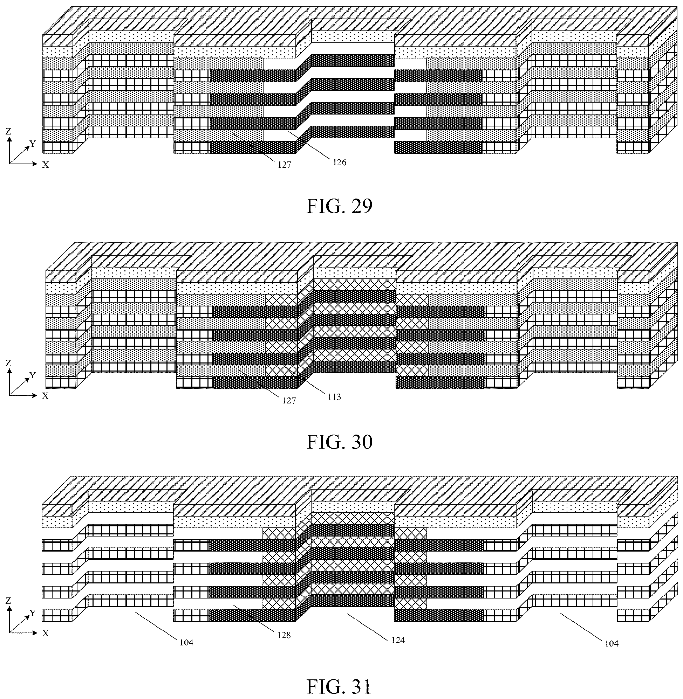

In some embodiments, as shown in FIG. 29 to FIG. 32, the second sacrificial layers 103 are removed to form multiple second filling regions, and a bit line layer 108 is formed in each of the second filling regions includes the steps as follows. Lateral etching is performed through the third trench 124 to remove a seventh portion of each of the second sacrificial layers 103 to form multiple seventh filling regions 126; a conductive material layer 113 is filled in each of the seventh filling regions 126; lateral etching is performed through the first trenches 104 to remove retained eighth portions 127 of each of the second sacrificial layers 103 to form multiple eighth filling regions 128; and the conductive material layer 113 is filled in each of the eighth filling regions 128, where the conductive material layers 113 in the seventh filling regions 126 and the eighth filling regions 128 constitute the bit line layers 108.

In some specific examples, a fifth sacrificial layer may be formed in each of the first trenches 104 when lateral etching is performed through the third trench 124 to remove the seventh portion of each of the second sacrificial layers 103, so that the first sacrificial layers 102 cannot be laterally etched through the first trenches 104 when lateral etching is performed through the third trench 124. After the conductive material layer 113 is filled in each of the seventh filling regions 126, the fifth sacrificial layer in each of the first trenches 104 is removed.

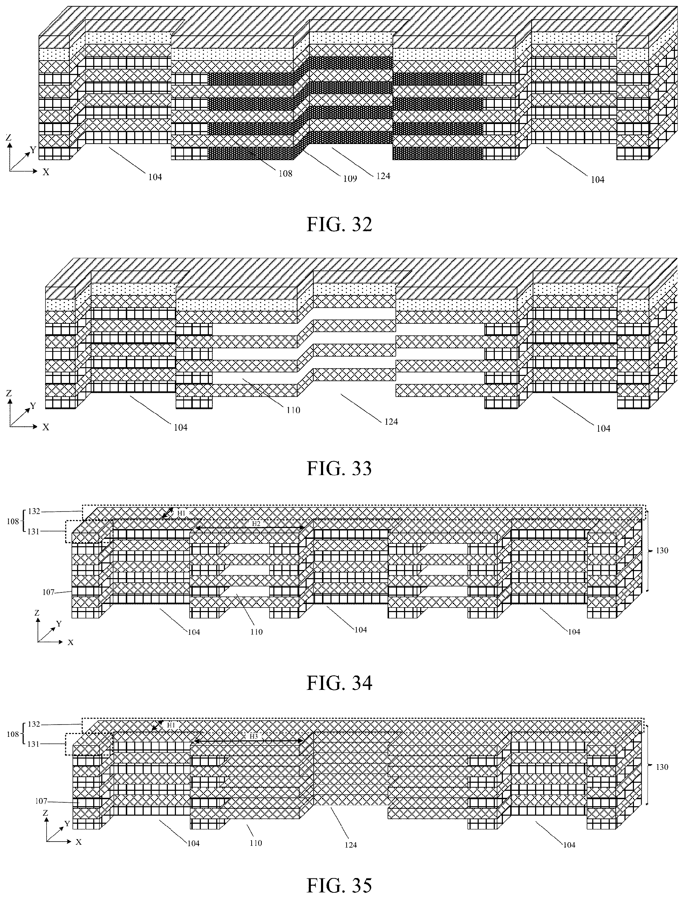

In some embodiments, as shown in FIG. 33, that the retained second portion 109 of each of the first sacrificial layers 102 is removed includes the step as follows. Lateral etching is performed through the third trench 124 to remove the retained second portion 109 of each of the first sacrificial layers 102.

In the embodiments of the present disclosure, the forming method for a semiconductor structure is provided, and includes the steps as follows. An initial stacked structure 101 is provided, where the initial stacked structure 101 includes first sacrificial layers 102 and second sacrificial layers 103 that are alternately stacked; multiple first trenches 104 running through the initial stacked structure 101 are formed; lateral etching is performed through the first trenches 104 to remove first portions of each of the first sacrificial layers 102 to form multiple first filling regions 106; a dielectric layer 107 is formed in each of the first filling regions 106; the second sacrificial layers 103 are removed to form multiple second filling regions, and a bit line layer 108 is formed in each of the second filling regions; and a retained second portion 109 of each of the first sacrificial layers 102 is removed to form multiple cavities 110. In the embodiments of the present disclosure, the first trenches 104 running through the initial stacked structure 101 are formed in the initial stacked structure 101. By performing lateral etching through the first trenches 104 to remove the first portions of each of the first sacrificial layers 102, after the dielectric layer 107 are filled in regions in which the first portions of each of the first sacrificial layers 102 are removed, and the second sacrificial layers 103 are removed and the bit line layers 108 are formed, the second portions 109 of the first sacrificial layers 102 are removed, so that each of the cavities 110 is formed between adjacent two bit line layers 108 in the stacking direction of the initial stacked structure 101. In this way, the coupling effect between adjacent two bit line layers 108 in the stacking direction of the initial stacked structure 101 can be alleviated, and the parasitic capacitance of adjacent two bit line layers 108 in the stacking direction of the initial stacked structure 101 can be reduced, thereby improving the performance of the semiconductor structure.

Based on the forming method for a semiconductor structure, an embodiment of the present disclosure provides a semiconductor structure. A semiconductor structure shown in FIG. 34 is corresponding to Solution 1 in the forming method for a semiconductor structure. A semiconductor structure shown in FIG. 35 is corresponding to Solution 2 and Solution 3 in the forming method for a semiconductor structure.

As shown in FIG. 34 and FIG. 35, the semiconductor structure includes a stacked structure 130, including bit line layers 108 and dielectric layers 107 that are alternately stacked, where the stacked structure 130 includes multiple first trenches 104 running through the stacked structure 130; each of the bit line layers 108 has multiple first bit line portions 131 located on two sides of each of the first trenches 104 in a first direction and a second bit line portion 132 located on one side of each of the multiple first bit line portions 131 in a second direction, and the second bit line portion 132 extends in the first direction; and dielectric layers 107 between adjacent ones of the first trenches 104 have cavities 110.

It may be understood that in this embodiment of the present disclosure, each of the cavities 110 exists between adjacent two bit line layers 108 in a stacking direction of the stacked structure 130, so that a coupling effect between the adjacent two bit line layers 108 in the stacking direction of the stacked structure 130 can be alleviated, and the parasitic capacitance generated between the adjacent two bit line layers 108 in the stacking direction of the stacked structure 130 can be reduced, thereby effectively improving the performance of a memory.

In some specific examples, the material of the bit line layer 108 includes but is not limited to metal tungsten.

It may be understood that, in this embodiment of the present disclosure, tungsten is adopted as the material of the bit line layer 108, to reduce the resistance of a bit line and improve the performance of the memory.

In some specific examples, the material of the dielectric layers 107 may be a low dielectric constant material, and the low dielectric constant material includes but is not limited to one of silicon oxide, silicon nitride, silicon carbide, silicon carbide nitride, or silicon oxynitride. It may be understood that the dielectric layer 107 in this embodiment of the present disclosure adopts the low dielectric constant material, so that the coupling effect between the adjacent two bit line layers 108 in the stacking direction of the stacked structure 130 can be further alleviated and the parasitic capacitance can be reduced.

In some embodiments, as shown in FIG. 34, the multiple first trenches 104 are arranged in the first direction, the width of the second bit line portion 132 in the second direction is H1, the width of each of the first bit line portions 131 in the first direction is H2, and the ratio of H2 to H1 is greater than 2; and the first direction is perpendicular to the second direction and both are perpendicular to the stacking direction of the stacked structure 130.

In some embodiments, the ratio of H2 to H1 ranges from 3 to 6.

In some embodiments, as shown in FIG. 34, each of the cavities 110 is located between adjacent ones of the first bit line portions 131 in the stacking direction, and each of the dielectric layers 107 exists between each of the cavities 110 and each of two adjacent ones of the first trenches 104 in the first direction.

In some embodiments, as shown in FIG. 35, a range of the ratio of H2 to H1 is greater than 6, the stacked structure 130 further includes a third trench 124 running through the stacked structure 130, the third trench 124 is located between two adjacent ones of the first trenches 104, the distance between the third trench 124 and one of the first trenches 104 adjacent to the third trench in the first direction is H3, and the ratio of H3 to H1 ranges from 3 to 6.

In some embodiments, the cavities 110 are located between adjacent ones of the first bit line portions 131 in the stacking direction and between adjacent second bit line portions 132 in the stacking direction, the cavities 110 are located on two sides of the third trench 124 in the first direction and on one side thereof in the second direction, each of the dielectric layers 107 exists between each of the first trenches 104 and each of the cavities 110, and the third trench 124 and the cavities 110 are in communication.

Based on the foregoing semiconductor structure, an embodiment of the present disclosure further provides a memory, including the semiconductor structure in any one of the foregoing embodiments.

In some specific examples, the memory includes but is not limited to a dynamic random access memory, a static random access memory (SRAM), a phase change random access memory (PCRAM), a magnetoresistive random access memory (MRAM), a ferroelectric random access memory (FeRAM), a resistive random access memory (RRAM), and a flash memory (Flash Memory).

In several embodiments provided in the present disclosure, it should be understood that the disclosed devices and methods may be implemented in a non-target manner. The device embodiments described above are merely examples. For example, the unit division is merely logical function division, and there may be another division manner in actual implementation. For example, multiple units or components may be combined or integrated into another system, or some features may be ignored or not performed. In addition, the displayed or discussed components are coupled to or directly coupled to each other.

The features disclosed in the several method or device embodiments provided in the present disclosure may be randomly combined when there is no conflict, to obtain new method embodiments or new device embodiments.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

### Industrial applicability

In the embodiments of the present disclosure, the first trenches running through the initial stacked structure are formed in the initial stacked structure. By performing lateral etching through the first trenches to remove the first portions of each of the first sacrificial layers, after the dielectric layers are filled in regions in which the first portions of each of the first sacrificial layers are removed, and the second sacrificial layers are removed and the bit line layers are formed, the second portions of the first sacrificial layers are removed, so that each of the cavities is formed between the adjacent two bit line layers in the stacking direction of the initial stacked structure. In this way, the coupling effect between the adjacent two bit line layers in the stacking direction of the initial stacked structure can be alleviated, and the parasitic capacitance of the adjacent two bit line layers in the stacking direction of the initial stacked structure can be reduced, thereby improving the performance of the semiconductor structure.

## Claims

1. A forming method for a semiconductor structure, comprising:
providing an initial stacked structure (101), the initial stacked structure (101) comprising first sacrificial layers (102) and second sacrificial layers (103) that are alternately stacked;
forming a plurality of first trenches (104) running through the initial stacked structure (101);
performing lateral etching through the first trenches (104) to remove first portions of each of the first sacrificial layers (102) to form a plurality of first filling regions (106);
forming a dielectric layer (107) in each of the first filling regions (106);
removing the second sacrificial layers (103) to form a plurality of second filling regions, and forming a bit line layer (108) in each of the second filling regions; and
removing a retained second portion (109) of each of the first sacrificial layers (102) to form a plurality of cavities (110).

2. The forming method according to claim 1, wherein the plurality of first trenches (104) are arranged in a first direction (X), a distance between a sidewall of each of the first trenches (104) parallel to the first direction (X) and an edge of the initial stacked structure (101) in a second direction (Y) is H1, a distance between two adjacent ones of the first trenches (104) in the first direction (X) is H2, and a ratio of H2 to H1 is greater than 2; and the first direction (X) is perpendicular to the second direction (Y) and both are perpendicular to a stacking direction (Z) of the initial stacked structure (101).

3. The forming method according to claim 1 or 2, wherein the removing the second sacrificial layers (103) to form a plurality of second filling regions, and forming a bit line layer (108) in each of the second filling regions comprises:
performing lateral etching through the first trenches (104) to remove third portions of each of the second sacrificial layers (103) to form a plurality of third filling regions (112);
filling each of the third filling regions (112) with a conductive material, wherein the conductive material is filled between retained fourth portions (114) of the second sacrificial layers (103);
removing the fourth portions (114) to form a plurality of fourth filling regions (115); and
filling each of the fourth filling regions (115) with the conductive material, wherein the conductive materials in the third filling regions (112) and the fourth filling regions (115) constitute the bit line layers (108).

4. The forming method according to claim 3, wherein after the dielectric layer (107) is formed in each of the first filling regions (106), the dielectric layer (107) is filled between the retained second portions (109) of each of the first sacrificial layers (102); and
the removing the fourth portions (114) and removing the second portions (109) comprise:
forming, after the conductive material is filled in each of the third filling regions (112), a second trench (116) running through the initial stacked structure (101), wherein the second trench (116) exposes sidewalls of the fourth portions (114) and sidewalls of the second portions (109);
performing lateral etching through the second trench (116) to remove the fourth portions (114); and
performing lateral etching through the second trench (116) to remove the second portions (109).

5. The forming method according to claim 1 or 2, further comprising:
filling at least a partial number of the first trenches (104) with a third sacrificial layer (117) before lateral etching is performed through the first trenches (104) to remove the first portions of each of the first sacrificial layers (102); and
removing the third sacrificial layer (117) after the dielectric layer (107) is formed in each of the first filling regions (106), to form a fourth trench (118), wherein the fourth trench (118) exposes sidewalls of the second portions (109).

6. The forming method according to claim 5, wherein the removing the second sacrificial layers (103) to form a plurality of second filling regions, and forming a bit line layer (108) in each of the second filling regions comprises:
filling each of the first trenches (104) with a fourth sacrificial layer (119), and performing lateral etching through the fourth trench (118) to remove a fifth portion of each of the second sacrificial layers (103) to form a plurality of fifth filling regions (123);
filling each of the fifth filling regions (123) with a conductive material;
removing the fourth sacrificial layer (119), and removing retained sixth portions (120) of each of the second sacrificial layers (103) through the first trenches (104) to form a plurality of sixth filling regions (121); and
filling each of the sixth filling regions (121) with the conductive material, wherein the conductive materials in the fifth filling regions (123) and the sixth filling regions (121) constitute the bit line layers (108).

7. The forming method according to claim 1, wherein the plurality of first trenches (104) are arranged in a first direction (X), and the method further comprises:
forming a third trench (124) between two adjacent ones of the first trenches (104) after the dielectric layer (107) is formed in each of the first filling regions (106), wherein the third trench (124) runs through the initial stacked structure (101) and exposes a sidewall of each of the second portions (109); a distance between the third trench (124) and one of the first trenches (104) adjacent to the third trench in the first direction (X) is H3, a distance between a sidewall of the third trench (124) or each of the first trenches (104) parallel to the first direction (X) and an edge of the initial stacked structure (101) in a second direction (Y) is H1, and a ratio of H3 to H1 is greater than 2; and the first direction (X) is perpendicular to the second direction (Y) and both are perpendicular to a stacking direction (Z) of the initial stacked structure (101).

8. The forming method according to claim 7, wherein the removing the second sacrificial layers (103) to form a plurality of second filling regions, and forming a bit line layer (108) in each of the second filling regions comprises:
performing lateral etching through the third trench (124) to remove a seventh portion of each of the second sacrificial layers (103) to form a plurality of seventh filling regions (126);
filling each of the seventh filling regions (126) with a conductive material;
performing lateral etching through the first trenches (104) to remove retained eighth portions (127) of each of the second sacrificial layers (103) to form a plurality of eighth filling regions (128); and
filling each of the eighth filling regions (128) with the conductive material, wherein the conductive materials in the seventh filling regions (126) and the eighth filling regions (128) constitute the bit line layers (108); and
the removing a retained second portion (109) of each of the first sacrificial layers (102) comprises: performing lateral etching through the third trench (124) to remove the retained second portion (109) of each of the first sacrificial layers (102).

9. A semiconductor structure, comprising:
a stacked structure (130), comprising bit line layers (108) and dielectric layers (107) that are alternately stacked;
the stacked structure (130) comprising a plurality of first trenches (104) running through the stacked structure (130);
each of the bit line layers (108) having a plurality of first bit line portions (131) located on two sides of each of the first trenches (104) in a first direction (X) and second bit line portions (132) located on one side of the plurality of first bit line portions (131) in a second direction (Y), and the second bit line portions (132) extending in the first direction (X); and
dielectric layers (107) between adjacent ones of the first trenches (104) have cavities (110).

10. The semiconductor structure according to claim 9, wherein the plurality of first trenches (104) are arranged in the first direction (X), a width of each of the second bit line portions (132) in the second direction (Y) is H1, a width of each of the first bit line portions (131) in the first direction (X) is H2, and a ratio of H2 to H1 is greater than 2; and the first direction (X) is perpendicular to the second direction (Y) and both are perpendicular to a stacking direction (Z) of the stacked structure (130).

11. The semiconductor structure according to claim 10, wherein the ratio of H2 to H1 ranges from 3 to 6.

12. The semiconductor structure according to any one of claims 9 to 11, wherein each of the cavities (110) is located between adjacent ones of the first bit line portions (131) in the stacking direction (Z), and each of the dielectric layers (107) exists between each of the cavities (110) and each of two adjacent ones of the first trenches (104) in the first direction (X).

13. The semiconductor structure according to claim 10, wherein a range of the ratio of H2 to H1 is greater than 6, the stacked structure (130) further comprises a third trench (124) running through the stacked structure (130), the third trench (124) is located between two adjacent ones of the first trenches (104), a distance between the third trench (124) and one of the first trenches (104) adjacent to the third trench in the first direction (X) is H3, and a ratio of H3 to H1 ranges from 3 to 6.

14. The semiconductor structure according to claim 13, wherein the cavities (110) are located between adjacent ones of the first bit line portions (131) in the stacking direction (Z) and between adjacent ones of the second bit line portions (132) in the stacking direction (Z), the cavities (110) are located on two sides of the third trench (124) in the first direction (X) and on one side thereof in the second direction (Y), each of the dielectric layers (107) exists between each of the first trenches (104) and each of the cavities (110), and the third trench (124) and the cavities (110) are in communication.

15. The semiconductor structure according to any one of claims 9 to 11, wherein the stacked structure (130) comprises a second trench (116) running through the stacked structure (130), and the second trench (116) extends in the first direction (X) and is in communication with the first trenches (104).

16. The semiconductor structure according to any one of claims 9 to 11, wherein a material of the bit line layer (108) comprises tungsten.

17. The semiconductor structure according to any one of claims 9 to 11, wherein a material of the dielectric layers (107) comprises one of silicon oxide, silicon nitride, silicon carbide, silicon carbide nitride, or silicon oxynitride.

18. A memory, comprising the semiconductor structure according to any one of claims 9 to 17.
